# EUROPÄISCHE PATENTANMELDUNG

(11) **EP 4 730 982 A1**
(43) Veröffentlichungstag der Anmeldung: **22.04.2026**
(21) Anmeldenummer: 25202600.0
(22) Anmeldetag: 16.09.2025
(51) Int. Cl.: H10W 72/00

(54) **FÜGEVERFAHREN ZUR HERSTELLUNG EINER VERBINDUNG ZWEIER OBERFLÄCHEN**

(30) Priorität: 17.09.2024 DE 102024208880
(71) Anmelder: Volkswagen Aktiengesellschaft, 38440 Wolfsburg (DE)
(72) Erfinder: BAYER, Christoph Friedrich, 38440 Wolfsburg (DE); KRAFT, Silke, 38440 Wolfsburg (DE); PIHALE, Sven, 38440 Wolfsburg (DE)

(57) **Zusammenfassung**

Die Erfindung betrifft ein Fügeverfahren zur Herstellung einer Verbindung zweier Oberflächen (18, 20), wobei wenigstens eine erste Oberfläche (18) eines ersten Fügepartners (12) mit einem Vorbehandlungsmedium vorbehandelt wird. Die erste Oberfläche (18) wird nach der Vorbehandlung mit einer zweiten Oberfläche (20) eines zweiten Fügepartners (22) stoffschlüssig verbunden. Das Vorbehandlungsmedium enthält wenigstens einen Alkohol und wenigstens eine reduzierende Säure.

## Beschreibung

Die Erfindung betrifft ein Fügeverfahren nach dem Oberbegriff des Anspruchs 1.

Aus der Praxis sind Fügeverfahren bekannt, bei denen wenigstens eine erste Oberfläche eines ersten Fügepartners mit einem Vorbehandlungsmedium vorbehandelt wird. Nach der Vorbehandlung wird die erste Oberfläche mit einer zweiten Oberfläche eines zweiten Fügepartners stoffschlüssig verbunden. Die Vorbehandlung dient dabei insbesondere dazu, die erste Oberfläche für die Herstellung der stoffschlüssigen Verbindung vorzubereiten. Dabei kann die Vorbehandlung dazu dienen, Verunreinigungen von der ersten Oberfläche zu entfernen, beispielsweise diese zu entfetten, und/oder die physikalischen und/oder chemischen Eigenschaften der ersten Oberfläche in einer für die Herstellung der stoffschlüssigen Verbindung günstigen Weise zu verändern, insbesondere Oxidschichten zu beseitigen, beispielsweise indem diese reduziert werden.

Bekannte Vorbehandlungen, die in Fügeverfahren zum Einsatz kommen, sehen oft eine vergleichsweise komplexe Prozessführung vor, bei der die Oberfläche mit einer Mehrzahl Medien in unterschiedlichen Schritten behandelt wird. Dies kann beispielsweise notwendig sein, um Rückstände eines zuvor eingesetzten Vorbehandlungsmediums zu entfernen. Dabei kann das Zurückbleiben von schützenden Schichten nach einzelnen Behandlungsschritten durchaus gewünscht sein, beispielsweise um eine Lagerung des behandelten Fügepartners vor dem Herstellen der stoffschlüssigen Verbindung zu ermöglichen. Typischerweise werden derartige schützende Schichten dann entweder kurz vor der Durchführung des Fügeverfahrens entfernt oder es kommen Fügeverfahren zum Einsatz, bei denen derartige Schichten das Zustandekommen der stoffschlüssigen Verbindung nicht verhindern. Im ersteren Fall bedeutet dies einen zusätzlichen Prozessschritt, im letzteren eine Einschränkung im Hinblick auf die Auswahl des infrage kommenden Verfahrens zur Herstellung der stoffschlüssigen Verbindung.

Aus der Herstellung von Halbleiterchips sind Verfahren bekannt, um oxidschichtfreie Kupferoberflächen herzustellen. Auf diese können bei der Herstellung der Halbleiterchips dann Schichten aus einem Halbleitermaterial, beispielsweise Siliziumnitrid, abgeschieden werden, beispielsweise mittels plasmaunterstützter chemischer Gasphasenabscheidung. Ein solches Verfahren ist beispielsweise in der US 2011/0045203 A1 offenbart. Dort kommt eine wässrige, glykolhaltige Lösung, die wenigstens eine organische Säure enthält, zum Einsatz, um eine im Wesentlichen oxidfreie Kupferoberfläche nach dem Entfernen einer Oxidschicht zu schützen, damit die Oberfläche bis zum Beginn der Gasphasenabscheidung auf diese Oberfläche oxidfrei bleibt.

Die CN 116 288 305 A beschreibt einen Passivierungsprozess für eine Kupferfolie. Dabei kommt ein Passivierungsmedium zum Einsatz, dass unter anderem organische Säuren enthalten kann. Eine derartige Passivierung geht jedoch auch mit dem Aufbau einer Schicht auf der Kupferfolie einher, die sich störend auf einen Fügeprozess auswirken kann.

Der Erfindung liegt daher die Aufgabe zugrunde, Fügeverfahren der in Rede stehenden Art, insbesondere im Hinblick auf die Vorbehandlung, zu vereinfachen.

Die Aufgabe wird gelöst durch ein Fügeverfahren mit den Merkmalen des unabhängigen Anspruchs 1. Die Merkmale der abhängigen Ansprüchen betreffen vorteilhafte Ausführungsformen.

Das Fügeverfahren zur Herstellung einer Verbindung zweier Oberflächen sieht vor, dass wenigstens eine erste Oberfläche eines ersten Fügepartners mit einem Vorbehandlungsmedium vorbehandelt wird. Nach der Vorbehandlung wird die erste Oberfläche mit einer zweiten Oberfläche eines zweiten Fügepartners stoffschlüssig verbunden.

Hierbei sieht das Verfahren insbesondere vor, dass zwischen der Vorbehandlung der ersten Oberfläche mit dem Vorbehandlungsmedium und dem Herstellen der stoffschlüssigen Verbindung keine weiteren Behandlungsschritte mit weiteren Medien mehr erfolgen. Mit anderen Worten, das Vorbehandlungsmedium ist das letzte Medium, mit dem zur Vorbereitung der ersten Oberfläche auf den Fügeprozess auf die erste Oberfläche in einer diese verändernden Art und Weise gezielt eingewirkt wird. Hierunter sind jedoch nicht die unvermeidbaren Einwirkungen der Umwelt auf diese Oberfläche zu verstehen, die beispielsweise dann erfolgen, wenn der erste Fügepartner nach der Vorbehandlung eine bestimmte Zeit gelagert wird, bevor er mit dem zweiten Fügepartner verbunden wird. Die Einwirkung beispielsweise der Umgebungsatmosphäre auf die erste Oberfläche während einer solchen Lagerzeit ist nicht als gezielte Behandlung mit einem Vorbehandlungsmedium zu verstehen.

Bei demHerstellen der stoffschlüssigen Verbindung können Verbindungsmaterialien, wie beispielsweise Lote, Lötpasten, Sinterpasten, Schweißzusätze genutzt werden, die vor dem Herstellen auf die erste und/oder auf die zweite Oberfläche aufgebracht werden und beim Herstellen der stoffschlüssigen Verbindung eine Anbindungsschicht zwischen der ersten und der zweiten Oberfläche ausbilden. Die Vorbehandlung kann dazu dienen die erste und/oder die zweite Oberfläche auf das Aufbringen des Verbindungsmaterials vorzubereiten. Alternativ kann das Herstellen der stoffschlüssigen Verbindung durch das direkte Verbinden der ersten Oberfläche mit der zweiten Oberfläche ohne die Verwendung eines Verbindungsmaterials erfolgen.

Das Fügeverfahren kann vorsehen, dass die erste Oberfläche vor der Vorbehandlung mit dem Vorbehandlungsmedium wenigstens einem weiteren Behandlungsschritt mit wenigstens einem weiteren Medium unterzogen wird. Dabei kann es sich beispielsweise um einen Reinigungsschritt handeln. Derartige Behandlungsschritte können unmittelbar und/oder mit einem Zeitversatz vor der Vorbehandlung der ersten Oberfläche mit dem Vorbehandlungsmedium erfolgen.

Die Aufgabe wird insbesondere dadurch gelöst, dass das Vorbehandlungsmedium wenigstens einen Alkohol und wenigstens eine reduzierende Säure enthält.

Es hat sich im Zusammenhang mit der vorliegenden Erfindung gezeigt, dass sich mit Vorbehandlungsmedien, die einen Alkohol und eine reduzierende Säure enthalten, Oberflächeneigenschaften erzeugen lassen, die für die spätere Herstellung einer stoffschlüssigen Verbindung im Rahmen eines Fügeverfahrens besonders vorteilhaft sind. Darüber hinaus können derartige Vorbehandlungsmedien vergleichsweise kostengünstig und umweltverträglich realisiert werden. Zu den vorteilhaften realisierbaren Eigenschaften derartiger Vorbehandlungsmedien zählen insbesondere deren reduzierende Wirkung auf metallische Oberflächen und deren Fähigkeit, diese über einen bestimmten Zeitraum zu schützen, unter der Einwirkung erhöhter Temperaturen jedoch rückstandsfrei entfernbar zu sein. Insbesondere bei Verfahren zur Herstellung einer stoffschlüssigen Verbindung, die mit einer Erhöhung der Temperatur der ersten Oberfläche einhergehen, lassen sich derartige Vorbehandlungsmedien daher besonders vorteilhaft einsetzen.

Bei der Säure kann es sich um Amidosulfonsäure und/oder eine organische Säure handeln. Die organische Säure kann Ascorbinsäure und/oder Zitronensäure sein. Diese Säuren haben sich in der Praxis als besonders geeignet für die reduzierende Behandlung von Oberflächen herausgestellt.

Bei dem Alkohol kann es sich insbesondere um Ethylenglykol handeln. Der Anteil der Säure an dem Vorbehandlungsmedium kann wenigstens 5 Gew%, insbesondere wenigstens 10 Gew%, und/oder höchstens 35 Gew%, insbesondere höchstens 20 Gew% betragen. Der Anteil des Alkohols bzw. der Alkohole kann wenigstens 65 Gew%, insbesondere wenigstens 80 Gew%, und/oder höchstens 95 Gew%, insbesondere höchstens 90 Gew%, betragen. Es hat sich gezeigt, dass insbesondere ein Vorbehandlungsmedium mit einem Anteil der Säure, insbesondere Ascorbinsäure, an dem Vorbehandlungsmedium von wenigstens 5 Gew% und höchstens 20 Gew% und einem Anteil des Alkohols bzw. der Alkohole, insbesondere des Ethylenglycols, von wenigstens 80 Gew% und höchstens 95 Gew%, gut für das Verfahren geeignet ist.

Das Vorbehandlungsmedium kann darüber hinaus wenigstens einen Zusatzstoff enthalten der Zusatzstoff kann insbesondere dazu dienen, einen schützenden Film auf der ersten Oberfläche auszubilden. Der wenigstens eine Zusatzstoff kann ausgewählt sein aus Polyelthylenglycol, insbesondere mit einer Molmasse von wenigstens 15 g/mol und/oder höchstens 40000g/mol, Polyvinylpyrrolidon, insbesondere mit einer Molmasse von wenigstens 15 g/mol und/oder höchstens 40000 g/mol, Polyalkylenenglycolether, Texanol, Polysaccharid, Vinylacetat und Wachs. Unter einem Wachs ist in diesem Zusammenhang insbesondere ein Wachs nach der Definition der Deutschen Gesellschaft für Fettwissenschaft zu verstehen, nach der ein Stoff als Wachs bezeichnet wird, wenn er bei 20 °C knetbar, fest bis brüchig-hart ist, eine grobe bis feinkristalline Struktur aufweist, farblich durchscheinend bis opak, aber nicht glasartig ist, über 40 °C ohne Zersetzung schmilzt, wenig oberhalb des Schmelzpunktes leicht flüssig (wenig viskos) ist, eine stark temperaturabhängige Konsistenz und Löslichkeit aufweist sowie unter leichtem Druck polierbar ist.

Bei dem ersten Fügepartner kann es sich um einen Schaltungsträger handeln. Unter einem Schaltungsträger ist in diesem Zusammenhang insbesondere ein flächiges Gebilde aus einem elektrisch isolierenden Substrat zu verstehen, wobei das Gebilde wenigstens an einer seiner Flächenseiten metallische Bereiche zur Ausbildung einer elektrischen Schaltung aufweist. Im Zusammenhang mit dem beschriebenen Fügeverfahren handelt es sich insbesondere um einen keramischen Schaltungsträger. Keramische Schaltungsträger können aufgrund ihrer Unempfindlichkeit gegenüber hohen Temperaturen insbesondere in leistungselektronischen Einrichtungen Anwendung finden.

Bei der leistungselektronischen Einrichtung kann es sich beispielsweise um eine Leistungsbox und/oder ein Leistungsmodul einer Leistungselektronik eines elektrischen Antriebs eines Kraftfahrzeugs handeln. Entsprechend ist das Fügeverfahren insbesondere Bestandteil eines Verfahrens zur Herstellung einer leistungselektronischen Einrichtung, insbesondere eines Verfahrens zur Herstellung einer leistungselektronischen Einrichtung eines elektrischen Antriebs eines Kraftfahrzeugs.

Bei der ersten Oberfläche kann es sich um eine metallische Oberfläche handeln. Die metallische Oberfläche ist insbesondere aus Kupfer, Silber, Gold, Zinn oder einer Legierung mit wenigstens einem der vorstehenden Metalle als Bestandteil, beispielsweise einer Kupferlegierung. Aufgrund der hohen Leitfähigkeit des Kupfers eignet sich dieses besonders gut als elektrisch leitender Bestandteil des ersten Fügepartners. Insbesondere dann, wenn die stoffschlüssige Verbindung elektrisch leitend gestaltet sein soll, ist eine Entfernung etwaiger Oxidschichten für das Zustandekommen einer stoffschlüssigen Verbindung mit einer guten Leitfähigkeit wesentlich. Daher lässt sich das beschriebene Verfahren aufgrund des Vorbehandlungsschritts bei derartigen Verbindungen besonders sinnvoll einsetzen.

Bei der ersten Oberfläche kann es sich insbesondere um eine metallische Oberfläche eines Schaltungsträgers handeln.

Bei dem zweiten Fügepartner kann es sich um ein Halbleiter handeln. Insbesondere dann, wenn das Fügeverfahren ein Verfahren zur Herstellung einer elektronischen Einrichtung ist, das dazu dient, einen Halbleiter auf eine metallische Oberfläche, insbesondere eine metallische Oberfläche eines Schaltungsträgers, zu fügen, bestehen hohe Anforderungen an die resultierende elektrische Leitfähigkeit der entstehenden stoffschlüssigen Verbindung,.

Bei dem Halbleiter kann sich insbesondere um ein Leistungshalbleiter handeln. Bei Leistungshalbleitern besteht die Herausforderung regelmäßig darin, dass über die stoffschlüssige Verbindung vergleichsweise hohe elektrische Leistungen übertragen werden müssen. Entsprechend hoch sind die Anforderungen an die Leitfähigkeit und damit an eine innige metallische Verbindung ohne Oxidschichten, die sich negativ auf die Leitfähigkeit im Bereich der stoffschlüssigen Verbindung auswirken.

Bei der zweiten Oberfläche kann es sich um eine Oberfläche einer Metallisierungsschicht des Halbleiters handeln. Insbesondere dann, wenn das Fügeverfahren Teil eines Verfahrens zur Herstellung einer elektronischen, insbesondere einer leistungselektronischen, Einrichtung ist, kann das Verfahren vorteilhaft genutzt werden, um eine insbesondere metallische erste Oberfläche stoffschlüssig mit einer Oberfläche einer Metallisierungsschicht eines Halbleiters zu verbinden.

Die Vorbehandlung kann das Auftragen und Entfernen des Vorbehandlungsmediums umfassen. Das Auftragen des Vorbehandlungsmediums kann beispielsweise mittels Dispensen, Jetten, Sprühen, Vernebeln, Verdüsen, Dip-Coaten, Fluten und/oder Spin-Coaten erfolgen.

Das Entfernen des Vorbehandlungsmediums erfolgt insbesondere rückstandslos. Eine rückstandslose Entfernung kann insbesondere das Erhitzen des Vorbehandlungsmediums umfassen. Das Erhitzen kann insbesondere bis zum Erreichen einer definierten Temperatur durch die vorbehandelte Oberfläche, beispielweise einer Temperatur von 150°C und/oder einer Temperatur oberhalb einer Zersetzungstemperatur des Vorbehandlungsmediums, erfolgen. Es hat sich gezeigt, dass beispielsweise ein Vorbehandlungsmedium, das aus einer Mischung aus Ethylenglykol und Ascorbinsäure besteht, durch das Erhitzender vorbehandelten Oberfläche auf eine Temperatur von wenigstens 150 °C thermisch zersetzt und somit rückstandsfrei von der vorbehandelten Oberfläche entfernt werden kann. Das Vorbehandlungsmedium kann dabei beispielsweise 13 % Gew% Ascorbinsäure und 87 Gew% Ethylenglykol enthalten.

Das stoffschlüssige Verbinden der Fügepartner kann durch Heißverpressen erfolgen. Das Heißverpressen erfolgt insbesondere ohne die Verwendung organischer Zusatzstoffe.

Das Heißverpressen ist insbesondere dazu geeignet, einen Halbleiter unmittelbar stoffschlüssig mit den Leiterbahnen eines Schaltungsträgers zu verbinden. Es hat sich gezeigt, dass mittels des beschriebenen Verfahrens die hierfür notwendigen Eigenschaften, insbesondere der metallischen Oberfläche des Schaltungsträgers, auf wirtschaftliche Weise sichergestellt werden können.

Das Verfahren kann vorsehen, dass durch das Vorbehandlungsmedium ein Anhaften des zweiten Fügepartners an dem ersten Fügepartner zur Vorbereitung des Fügeprozesses bewirkt wird. Mit anderen Worten kann das Vorbehandlungsmedium im Rahmen des Fügeverfahrens als Tacking-Agent dienen. So kann das Vorbehandlungsmedium beispielsweise bewirken, dass ein zunächst auf einer metallischen Oberfläche eines Schaltungsträgers platzierter Halbleiter zunächst an der gewünschten Position anhaftet, bevor es in einem weiteren Verfahrensschritt, beispielsweise mittels eines Heißverpressens, mit der metallischen Oberfläche des Schaltungsträgers stoffschlüssig verbunden wird. Dies kann insbesondere eine Prozessautomatisierung erheblich vereinfachen, beispielsweise wenn unterschiedliche Vorrichtungen genutzt werden, um den Halbleiter zunächst mittels einer Vorrichtung an der gewünschten Position auf dem Schaltungsträger zu platzieren und ihn dann mittels einer weiteren Vorrichtung mit dem Schaltungsträger stoffschlüssig zu verbinden.

Weitere praktische Ausführungsformen der Erfindung sind nachfolgend im Zusammenhang mit den Zeichnungen beschrieben. Es zeigen:
- Fig. 1: einen beispielhaften mittels des Fügeverfahrens hergestellten Bestandteil einer leistungselektronischen Einrichtung,
- Fig. 2: einen beispielhaften mittels des Fügeverfahrens hergestellten Bestandteil einer leistungselektronischen Einrichtungen nach einer weiteren Ausführungsform.

Der beispielhaft dargestellte Bestandteil 10 einer leistungselektronischen Einrichtung weist einen ersten Fügepartner 12 auf, bei dem es sich wie in den gezeigten Beispielen um einen keramischen Schaltungsträger handeln kann. Der erste Fügepartner 12 kann wie in den gezeigten Beispielen eine keramische Trägerschicht 14 und wenigstens an einer seiner Flächenseiten eine metallische Schicht 16, beispielsweise eine Kupferschicht oder eine Schicht aus einer Kupferlegierung, aufweisen. Im gezeigten Beispiel kann an einer Flächenseite des ersten Fügepartners 12 mittels der metallischen Schicht 16 eine elektrische Verschaltung gebildet sein, wobei die metallische Schicht 16 eine erste Oberfläche 18 ausbildet. Die erste Oberfläche 18 wird im Rahmen des beispielhaften Fügeverfahrens stoffschlüssig mit einer zweiten Oberfläche 20 eines zweiten Fügepartner 22 stoffschlüssig verbunden. Bei dem zweiten Fügepartner 22 kann es sich wie in den gezeigten Beispielen um einen Leistungshalbleiter handeln, die zweite Oberfläche 18 kann wie in den Beispielen durch eine Metallisierungsschicht des Halbleiters gebildet sein.

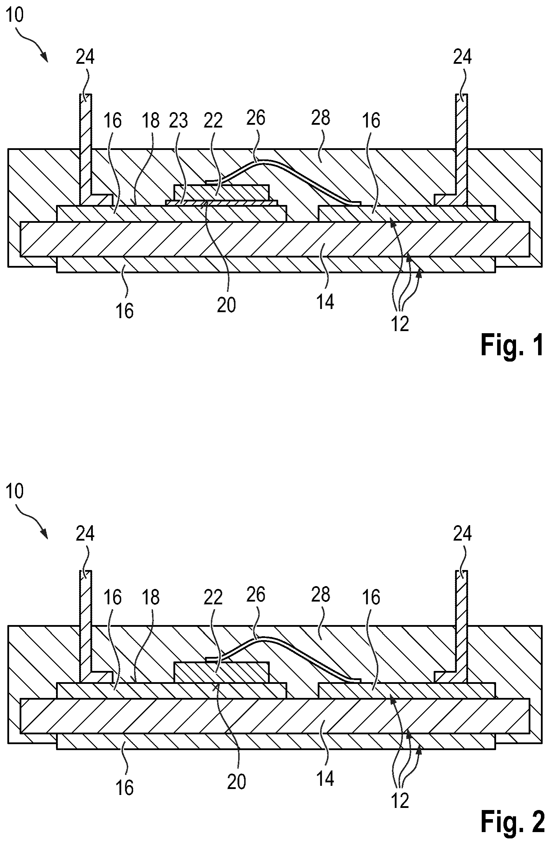

Im Fall des in Figur 1 dargestellten Ausführungsbeispiels ist zwischen dem zweiten Fügepartner 22 in Gestalt des Leistungshalbleiters und der ersten Oberfläche 18 der metallischen Schicht 16 des ersten Fügepartners 12 einer Anbindungsschicht 23 ausgebildet. Ein diesem Ausführungsbeispiel entsprechender Schichtaufbau entsteht, wenn die stoffschlüssige Verbindung mittels eines Verbindungsmaterials, wie beispielsweise einem Sintermaterial, insbesondere einer Sinterpaste, oder einem Lotmaterial, hergestellt wird. Alternativ kann, wie dies in dem in Figur 2 gezeigten Ausführungsbeispiel dargestellt ist, die stoffschlüssige Verbindung zwischen der ersten Oberfläche 18 und der zweiten Oberfläche 20 unmittelbar erfolgen. Beispielsweise kann der zweite Fügepartner 22 mittels Heißverpressen mit dem ersten Fügepartner 12 verbunden worden sein, um eine dem in Figur 2 gezeigten Ausführungsbeispiel entsprechende stoffschlüssige Verbindung zu erzeugen.

Im Fall beider gezeigte Ausführungsbeispiele sind die Oberflächen 18 und 20 der Fügepartner 12 und 22 nach einer Vorbehandlung der ersten Oberfläche 18 des ersten Fügepartners 12 mit einem Vorbehandlungsmedium stoffschlüssig verbunden worden. Bei dem Vorbehandlungsmedium kann es sich beispielhaft um ein Vorbehandlungsmedium, das 13 Gew% Ascorbinsäure und 87 % Ethylenglykol enthält, handeln. Die beispielhaften Fügeverfahren können dabei insbesondere vorsehen, dass das Vorbehandlungsmedium auf die erste Oberfläche 18 zunächst aufgetragen wird. Es hat sich gezeigt, dass ein derartiges Vorbehandlungsmedium einen wirksamen Schutz der vorbehandelten Oberfläche über einen Zeitraum von bis zu drei Tagen ermöglicht. Dies bedeutet, dass die so vorbehandelte Oberfläche 18 bzw. der so vorbehandelte erste Fügepartner 12 bis zu drei Tage zwischengelagert werden kann, bevor die Herstellung der stoffschlüssigen Verbindung erfolgt. Das Vorbehandlungsmedium kann im Rahmen der Herstellung der in den Figuren 1 und 2 gezeigten beispielhaften Bestandteile 10 leistungselektronischer Einrichtungen genutzt werden, um ein Anhaften des zweiten Fügepartner 22 in Gestalt des Leistungshalbleiters an dem ersten Fügepartner 12 zur Vorbereitung des stoffschlüssigen Verbindendes zu bewirken. Dies ist insbesondere vorteilhaft, wenn wie im Fall des in Figur 2 beispielhaft dargestellten Beispiels kein Zusatzstoff zum Herstellen der stoffschlüssigen Verbindung genutzt wird.

Das Fügeverfahren kann in den gezeigten Beispielen ein vollständiges Entfernen des Vorbehandlungsmediums durch das Erhitzen auf eine Temperatur von oberhalb von 150 °C vorsehen. Das Erhitzen kann zweckmäßigerweise im Rahmen des stoffschlüssigen Verbindens erfolgen, beispielsweise um ein anschließendes Heißverpressen im Fall des in Figur 2 dargestellten Ausführungsbeispiels oder ein Sintern im Fall des in Figur 1 dargestellten Ausführungsbeispiels zu ermöglichen.

Die in den Figuren beispielhaft dargestellten beispielhaften Bestandteile 10 leistungselektronischer Einrichtungen können wir in den gezeigten Beispielen weitere Bestandteile, wie beispielsweise elektrische Anschlusselemente 24 und Bonddrähte 26 aufweisen. Die Fügepartner 22 und 12 können, wie in den gezeigten Beispielen dargestellt, nach dem Herstellen der stoffschlüssigen Verbindung mittels einer Isolationsmasse 28 vergossen werden.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: Bestandteil einer Leistungselektronischen Einrichtung
- 12: erster Fügepartner
- 14: keramische Trägerschicht
- 16: metallische Schicht
- 18: erste Oberfläche
- 20: zweite Oberfläche
- 22: zweiter Fügepartner
- 23: Anbindungsschicht
- 24: elektrische Anschlusselemente
- 26: Bonddrähte
- 28: Isolationsmasse

## Patentansprüche

1. Fügeverfahren zur Herstellung einer Verbindung zweier Oberflächen (18, 20),
wobei wenigstens eine erste Oberfläche (18) eines ersten Fügepartners (12) mit einem Vorbehandlungsmedium vorbehandelt wird,
wobei die erste Oberfläche (18) nach der Vorbehandlung mit einer zweiten Oberfläche (20) eines zweiten Fügepartners (22) stoffschlüssig verbunden wird,
**dadurch gekennzeichnet,**
**dass** das Vorbehandlungsmedium wenigstens einen Alkohol und wenigstens eine reduzierende Säure enthält.

2. Fügeverfahren nach Anspruch 1, **dadurch gekennzeichnet, dass** es sich bei der Säure um Amidosulfonsäure und/oder eine organische Säure, insbesondere Ascorbinsäure und/oder Zitronensäure, handelt.

3. Fügeverfahren nach einem der vorigen Ansprüche, **dadurch gekennzeichnet, dass** es sich bei dem Alkohol um Ethylenglycol handelt.

4. Fügeverfahren nach einem der vorigen Ansprüche, **dadurch gekennzeichnet, dass** es sich bei dem ersten Fügepartner (12) um einen Schaltungsträger, insbesondere um einen keramischen Schaltungsträger, handelt.

5. Fügeverfahren nach einem der vorigen Ansprüche, **dadurch gekennzeichnet, dass** es sich bei der ersten Oberfläche (18) um eine metallische Oberfläche, insbesondere aus Kupfer oder einer Kupferlegierung handelt.

6. Fügeverfahren nach einem der vorigen Ansprüche, **dadurch gekennzeichnet, dass** es sich bei dem zweiten Fügepartner (22) um einen Halbleiter, insbesondere um einen Leistungshalbleiter handelt.

7. Fügeverfahren nach Anspruch 6, **dadurch gekennzeichnet, dass** es sich bei der zweiten Oberfläche (20) um eine Oberfläche einer metallisierungsschicht des Halbleiters handelt.

8. Fügeverfahren nach einem der vorigen Ansprüche, **dadurch gekennzeichnet, dass** die Vorbehandlung das Auftragen und, insbesondere rückstandslose, Entfernen des Vorbehandlungsmediums umfasst.

9. Fügeverfahren nach einem der vorigen Ansprüche, **dadurch gekennzeichnet, dass** das stoffschlüssige Verbinden der Fügepartner (12, 22) durch Heißverpressen erfolgt.

10. Fügeverfahren nach einem der vorigen Ansprüche, **dadurch gekennzeichnet, dass** durch das Vorbehandlungsmedium ein Anhaften des zweiten Fügepartners (22) an dem ersten Fügepartner (12) zur Vorbereitung des stoffschlüssigen Verbindens bewirkt wird.
